# FASCICULE DE BREVET EUROPEEN

(11) **EP 0 760 180 B1**
(45) Date de publication et mention de la délivrance du brevet: **10.11.1999**
(21) Numéro de dépôt: 96906822.0
(22) Date de dépôt: 13.03.1996
(51) Int. Cl.: H03K 3/84

(54) **PROCEDE ET DISPOSITIF DE COMMUTATION PSEUDO-ALEATOIRE**
VERFAHREN UND EINRICHTUNG FÜR PSEUDOZUFALLSSCHALTEN
PSEUDO-RANDOM SWITCHING DEVICE AND METHOD

(30) Priorité: 14.03.1995 FR 9502947
(43) Date de publication de la demande: 05.03.1997
(73) Titulaire: THOMSON multimedia, 92648 Boulogne Cédex (FR)
(72) Inventeur: COMMINGES, Martial, La Défense 5 F-92400 Courbevoie (FR); PAILLARDET, Frédéric, La Défense 5 F-92400 Courbevoie (FR); DELL'OVA, Francis, La Défense 5 F-92400 Courbevoie (FR)
(74) Mandataire: Ruellan-Lemonnier, Brigitte
(86) Numéro de dépôt international: FR9600387
(87) Numéro de publication internationale: WO9628888

(56) Documents cités:
- EP-A- 0 115 897
- US-A- 3 982 172
- US-A- 4 225 816
- US-A- 4 542 332

## Description

L'invention a pour objet un procédé et un dispositif de commutation aléatoire notamment de sources de courant ou de tension. L'invention est utilisée notamment dans des modulateurs multi-bit pour systèmes audio numériques (disques optiques ou magnéto-optiques, télévision numérique).

Il est nécessaire dans certains circuits d'adresser un nombre donné de sources de courant parmi une pluralité de ces sources pour en additionner le courant. Ce type d'adressage peut par exemple être utilisé dans un modulateur multibits pour la génération de plusieurs niveaux de courant distincts. Ces niveaux peuvent être obtenus en additionnant les courants issus d'autant de sources de courant que nécessaire.

Or, il est difficile de réaliser des sources de courant débitant des courants strictement identiques, étant donné les variations des caractéristiques locales d'un substrat de circuit intégré et des possibilités des procédés de fabrication actuellement utilisés pour ce type de circuit. Ces contraintes font que des sources de courant débitent des courants avec une certaine marge d'erreur.

Pour réduire l'influence de ces erreurs, il est connu de commuter, avant adressage, les sources de courant de manière aléatoire et équiprobable, de manière à ne pas obtenir toujours la même erreur pour un même niveau. Par exemple, lorsque huit sources sont à adresser, le niveau de valeur "1" parmi les huit niveaux possibles pourra être obtenu par l'allumage de n'importe laquelle des huit sources, le niveau de valeur "2" pouvant être obtenu par allumage d'une sélection de deux sources parmi les huit sources etc...

Un procédé de commutation connu dit "Butterfly" (littéralement "papillon" en référence à la disposition des commutateurs utilisés) est employé dans des applications nécessitant un nombre de sources de courant égal à une puissance de deux. Ce procédé sera vu plus en détail par la suite. Dans le cas où ce nombre de sources de courant est différent d'une puissance de deux, le procédé "Butterfly" n'est pas adapté, la commutation des sources ne se faisant pas de manière équiprobable, ce qui induit une distorsion indésirable de la moyenne d'erreurs.

L'invention a pour objet un dispositif de commutation pseudo-aléatoire de N sources de courant ou de tension caractérisé en ce qu'il comporte
- un premier moyen de commutation des N sources vers une première série de N connecteurs de sortie,
- un second moyen de commutation des N sources vers une seconde série de N connecteurs de sortie, ledit second moyen réalisant la commutation des sources avec des probabilités symétriques par rapport à une valeur d'équiprobabilité par rapport au premier moyen,
- des moyens de multiplexage des connecteurs symétriques de sortie de chacun des premier et second moyens et reliant à N sorties l'une desdites séries de manière sensiblement équiprobable.

Selon un mode de réalisation particulier de l'invention, lesdits moyens de commutation sont constitués par des réseaux identiques de commutateurs à deux entrées et deux sorties commandés par un même générateur de séquences aléatoires, les N entrées d'un des moyens de commutation étant connectées auxdites sources en ordre inverse par rapport à l'autre moyen de commutation.

Selon un mode de réalisation particulier, les N connecteurs de sortie des deux réseaux identiques de commutateurs sont référencés en ordre inverse l'un par rapport à l'autre, les moyens de multiplexage multiplexant vers une même sortie desdits moyens de multiplexage l'une des sorties des moyens de commutation parmi deux sorties de même référence.

Selon un mode de réalisation particulier, lesdits réseaux de commutateurs sont des réseaux de type "Butterfly".

Selon un mode de réalisation particulier, le multiplexage de l'une ou l'autre série de connecteurs de sortie est commandé par un bit supplémentaire du générateur pseudo-aléatoire.

Selon un mode de réalisation particulier, ledit générateur pseudo-aléatoire comprend un registre à décalage à boucle de retour réalisée en connectant à l'entrée de ce registre la sortie d'un ou exclusif dont les entrées sont connectées à un nombre donné de mémoires dudit registre.

L'invention a aussi pour objet un procédé de commutation pseudo-aléatoire de N sources de courant ou de tension caractérisé en ce qu'il comporte:
une première étape de commutation des N sources vers une première série de N connecteurs de sortie,
une seconde étape de commutation des N sources vers une seconde série de N connecteurs de sortie, les probabilités de commutation lors de la seconde étape étant symétriques de celles de la première étape par rapport à l'équiprobabilité,
une étape de multiplexage sensiblement équiprobable de l'une ou l'autre série de N connecteurs de sortie vers N sorties.

Selon un mode de réalisation particulier, l'étape de multiplexage est commandée par un bit d'un générateur pseudo-aléatoire.

D'autres caractéristiques de l'invention apparaîtront à travers la description d'un exemple de réalisation non limitatif illustré par les figures jointes parmi lesquelles
- la figure 1 représente un dispositif d'adressage de huit sources de courant par l'intermédiaire d'un réseau de commutateurs géré par un procédé de type "Butterfly",
- la figure 2 représente un dispositif d'adressage d'un nombre de sources de courant non égal à une puissance de 2,
- la figure 3 représente un graphe de la distribution donnant le nombre pondéré d'allumages de chaque source du dispositif de la figure 2 en fonction du numéro de ladite source,
- la figure 4 représente un dispositif d'adressage conforme à l'invention.

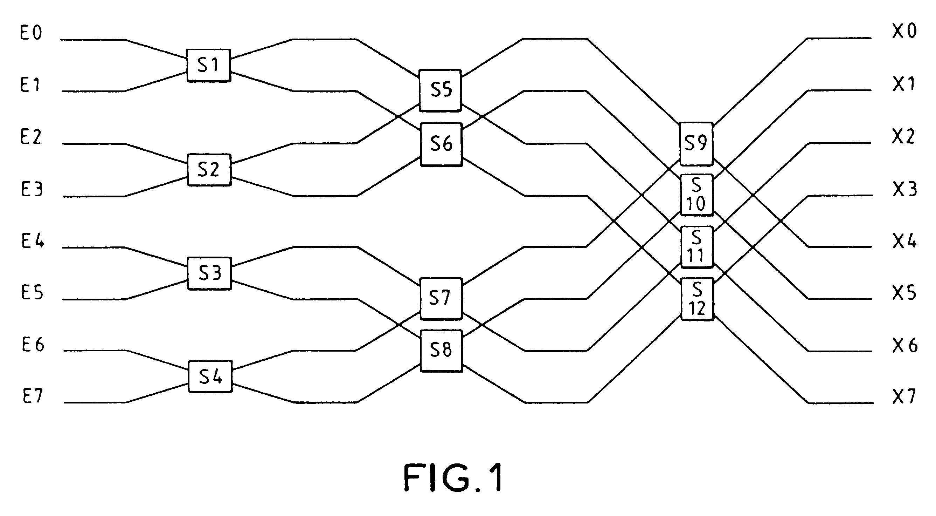

La figure 1 illustre un dispositif d'adressage de huit sources de courant grâce à un procédé de type "Butterfly" gérant un réseau de commutateurs. Les huit sources de courant sont référencées E0 à E7. Les huit sorties du dispositif sont référencées X0 à X7. Le but du dispositif est de permettre de connecter n'importe laquelle des huit sources E0 à E7 à n'importe laquelle des sorties, et ce de façon équiprobable. Pour ce faire, le dispositif comporte douze commutateurs S1 à S12 possédant chacun deux entrées et deux sorties. Suivant le signal de commande transmis aux commutateurs, ceux-ci commutent chacun des deux signaux à leur entrée vers l'une ou l'autre de leurs sorties. Les entrées de chaque commutateur sont reliées à deux sources de courant ou aux sorties de deux commutateurs eux même reliés directement ou indirectement à des ensembles disjoints de sources de courant. Etant donné que chaque source de courant doit pouvoir être multiplexée vers une parmi 2^3 sorties, elle doit traverser trois commutateurs.

Les douze commutateurs sont commandés par un générateur de séquences pseudo-aléatoires réalisé par l'intermédiaire d'un registre à décalage de 12 bascules, les sorties de certaines bascules étant soumises à un OU exclusif, le résultat de cette opération étant rebouclé sur l'entrée de la première bascule. On génère ainsi à la sortie de chacune des bascules une séquence de bits pseudo-aléatoire de période 2^12 - 1 = 4095 bits.

La réalisation de tels générateurs de séquences pseudo-aléatoires est bien connue de l'homme du métier et ne sera pas décrite plus en détail. Pour plus d'informations, on se réferera par exemple aux pages 579 à 586 de l'ouvrage "Communication Systems" de Simon Haykin publié aux éditions John Wiley & Sons 1994.

De façon générale, un générateur pseudo-aléatoire de ce type, possédant n bascules en série génère 2^n - 1 mots de n bits, le mot composé uniquement de zéros étant interdit. Pendant une période, chaque bascule est donc 2^(n-1) fois à l'état 1 et 2^(n-1) - 1 fois à l'état 0. L'état O et l'état 1 sont donc sensiblement équiprobables.

En revenant à la figure 1, chaque commutateur répond à l'état d'un bit du registre à décalage du générateur pseudo-aléatoire. Ainsi, à chaque coup d'horloge, l'état des commutateurs change et modifie le chemin entre les sources de courant et les sorties. Chaque sortie est reliée à une source de courant et à une seule.

Or, il apparaît que le type de dispositif illustré à la figure 1 n'est pas adapté lorsqu'un nombre de sources non égal à une puissance de deux doit être adressé. En effet, dans ce cas, les commutateurs ne peuvent être disposés pour commuter les courants de façon totalement homogène. Il en résulte un déséquilibre dans l'adressage des sources de courant: certaines seront adressées plus souvent que d'autres. Ceci aura pour conséquence un moyennage moins efficace des erreurs sur les valeurs des sources.

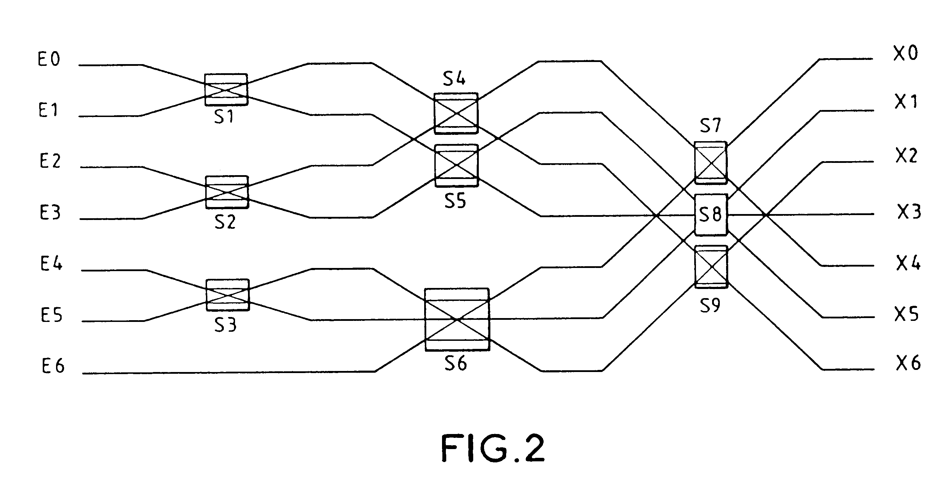

La figure 2 illustre un dispositif d'adressage aléatoire de sept sources E0 à E6. On utilise dans ce cas un réseau de neuf commutateurs semblables à ceux déjà décrits pour la figure 1. Ces neuf commutateurs sont organisés en trois étages de commutation.

Dans un premier temps, les interrupteurs S1, S2 et S3 commutent respectivement les paires de sources (E0,E1), (E2,E3) et (E4,E5). La source E6 n'est commutée qu'à l'étage suivant. Etant donné que le nombre de sources est impair, une source parmi les sept ne sera pas commutée par étage de commutateurs.

Dans un second temps, chaque couple d'entrée des commutateurs S4 et S5 est composé d'une sortie du commutateur S1 et d'une sortie du commutateur S2. Un commutateur S6 commute la source E6 avec l'une des deux sorties du commutateur S3. La sortie du commutateur S3 qui n'est pas reliée à l'entrée de S6 est passée directement au commutateur S8 du troisième étage.

Dans un troisième temps, un commutateur S7 commute une sortie de S4 et une sortie de S6, tandis qu'un commutateur S9 commute une sortie de S4 et une sortie de S6. S8 commute la sortie de S3 précédemment mentionnée et une sortie de S5. L'autre sortie de S5 n'est pas commutée par le troisième étage.

Les sorties de S7, S8, S9 et la sortie non commutée de S5 forment respectivement les sorties 0, 4, 1, 5, 2, 6 et 3 du dispositif.

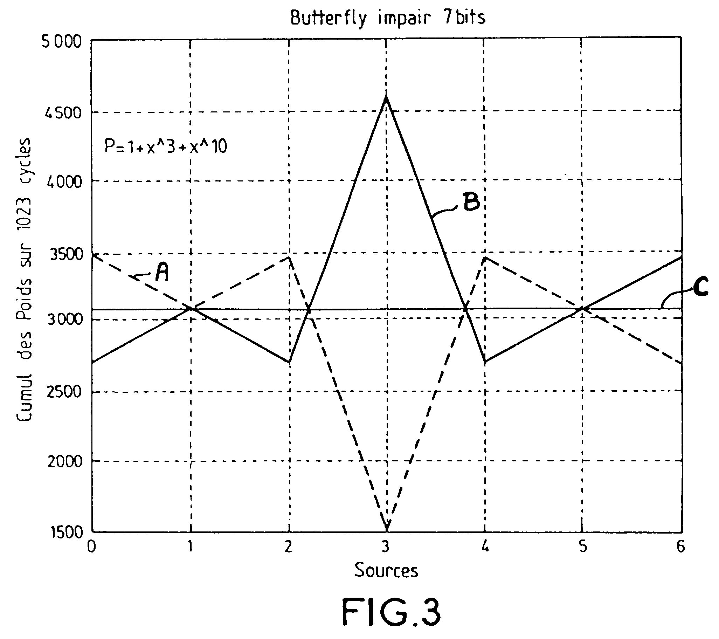

La courbe A de la figure 3 donne pour chaque sortie du dispositif une somme pondérée des sources qu'elle reçoit sur un cycle du générateur pseudo-aléatoire. Quand une sortie X reçoit la source 3, la valeur "3" est accumulée, pour la source 6, c'est la valeur 6 etc... S'il y avait équiprobabilité, la somme résultante pour chaque sortie devrait être la même. Or, il s'avère que ce n'est pas le cas: la sortie 3 reçoit notamment certaines sources de grand coefficient de pondération beaucoup moins souvent que d'autres. La ligne d'équiprobabilité est donnée par la ligne C. Il est à noter que les courbes de la figure 3 correspondent à un générateur pseudo-aléatoire caractérisé par le polynôme P= 1 + X^3 + X^10.

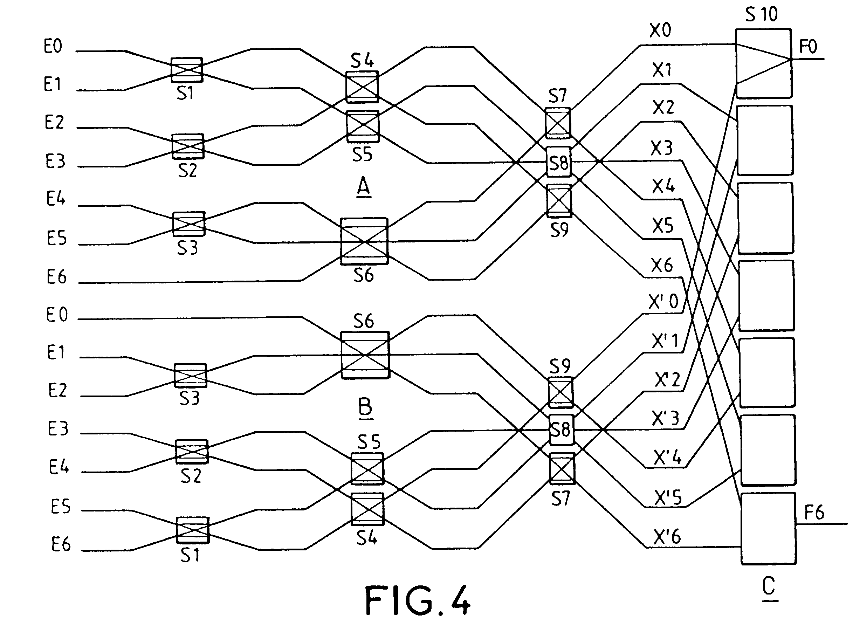

La figure 4 illustre le dispositif conforme au présent exemple de réalisation. Ce dispositif comporte deux réseaux A et B de commutateurs reliés entre eux d'une façon particulière. Les deux réseaux sont en soi identiques à celui de la figure 2. Les commutateurs des deux réseaux sont commandés par le même générateur de séquences pseudo-aléatoires. Le premier réseau relie les sources E0 à E6 aux sorties X0 à X6. Le second réseau est symétrique du premier dans le sens où les sources E0 à E6 sont présentées en ordre inversé à ses entrées. En l'occurrence, l'entrée du réseau connectée à la source E0 dans le premier réseau est connectée à la source E6 dans le second réseau. Il en est de même des sorties des deux réseaux. Les sorties du premier réseau sont référencées X0 à X6 tandis que les sorties du second réseau sont référencées X'0 à X'6.

Il est à noter que le schéma de la figure 4 inverse le réseau lui-même plutôt que l'ordre des sources et les sorties, mais cette disposition est équivalente.

Le dispositif comporte en outre sept multiplexeurs à deux entrées et une sortie, les entrées de chaque multiplexeur étant connectées aux sorties de même numéro. L'ensemble des multiplexeurs (référence C sur la figure 4) est commandé par un même bit du générateur de séquences pseudo-aléatoires. En conséquence, les sept sorties des multiplexeurs sont connectées soit entièrement aux sorties du premier réseau, soit entièrement aux sorties du second réseau. Une source de courant n'est donc jamais sollicitée en même temps par les deux réseaux. La fonction du multiplexage est de réaliser un moyennage des probabilités d'allumage des deux réseaux.

La courbe B de la figure 4 est l'équivalent pour le second réseau de la courbe A du premier réseau. On voit que la symétrie au niveau des sources de courant et des sorties a pour effet une symétrie des courbes A et B par rapport à la droite C. En l'occurence, la courbe C est la demi-somme des courbes A et B. On revient donc sensiblement à une équiprobabilité de l'adressage des sources de courant.

Avec le polynôme P précédemment défini, les courbes résultant d'un simulation numérique sur 1023 cycles ont les coordonnées définies dans le tableau 1.

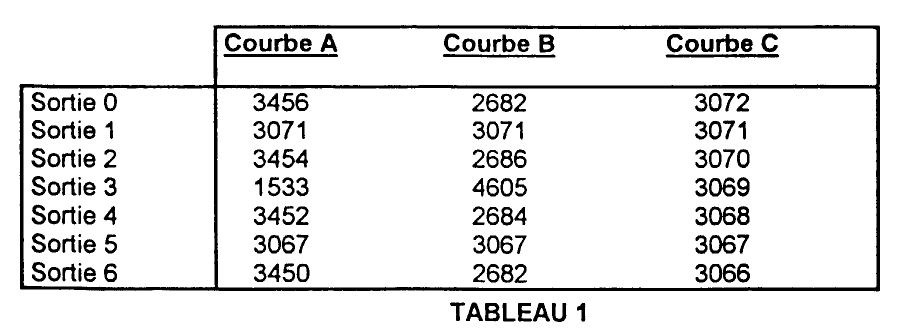

Le présent exemple de réalisation concerne un nombre impair de sources, mais l'invention se laisse aisément généraliser à un nombre quelconque de sources non égal à une puissance de deux.

L'invention ne se limite pas à un adressage pseudo-aléatoire de sources de courant, mais peut également être utilisé pour d'autres applications, notamment l'adressage de sources de tension.

## Revendications

1. Dispositif de commutation pseudo-aléatoire de N sources de courant ou de tension (E0 - E6) caractérisé en ce qu'il comporte
- un premier moyen de commutation (A) des N sources vers une première série de N connecteurs de sortie (X0 - X6),
- un second moyen de commutation (B) des N sources vers une seconde série de N connecteurs de sortie (X'0 - X'6), ledit second moyen réalisant la commutation des sources avec des probabilités symétriques par rapport à une valeur d'équiprobabilité par rapport au premier moyen,
- des moyens de multiplexage (C) des connecteurs symétriques ((X0,X'0) - (X6,X'6)) de sortie de chacun des premier et second moyens et reliant à N sorties (F0 - F6) l'une desdites séries de manière sensiblement équiprobable.

2. Dispositif selon la revendication 1, caractérisé en ce que lesdits moyens de commutation (A, B) sont constitués par des réseaux identiques de commutateurs (S1 - S9) à deux entrées et deux sorties, les mêmes commutateurs des deux réseaux (A,B) étant commandés par un même bit d'un générateur de séquences aléatoires, les N entrées d'un des moyens de commutation étant connectées auxdites sources (E0 - E6) en ordre inverse par rapport à l'autre moyen de commutation.

3. Dispositif selon la revendication 2, caractérisé en ce que les N connecteurs de sortie (X0 - X6, X'0 - X'6) des deux réseaux identiques (A,B) de commutateurs sont référencés en ordre inverse l'un par rapport à l'autre, les moyens de multiplexage (C) multiplexant vers une même sortie (F0 - F6) desdits moyens de multiplexage l'une des sorties des moyens de commutation parmi deux sorties de même référence ((X0,X'0),(X6,X'6)).

4. Dispositif selon l'une des revendications 2 ou 3, caractérisé en ce que lesdits réseaux de commutateurs (A, B) sont des réseaux de type "Butterfly".

5. Dispositif selon l'une des revendications 2 à 4, caractérisé en ce que le multiplexage de l'une ou l'autre série de connecteurs de sortie est commandé par un bit supplémentaire (S10) du générateur de séquences aléatoires.

6. Dispositif selon l'une des revendications 2 à 5, ledit générateur de séquences aléatoires comprend un registre à décalage à boucle de retour réalisée en connectant à l'entrée de ce registre la sortie d'un ou exclusif dont les entrées sont connectées à un nombre donné de mémoires dudit registre.

7. Procédé de commutation pseudo-aléatoire de N sources (E0-E6) de courant ou de tension caractérisé en ce qu'il comporte:
une première étape de commutation des N sources vers une première série (X0 - X6) de N connecteurs de sortie,
une seconde étape de commutation des N sources vers une seconde série (X'0 - X'6) de N connecteurs de sortie, les probabilités de commutation lors de la seconde étape étant symétriques de celles de la première étape par rapport à l'équiprobabilité,
une étape de multiplexage sensiblement équiprobable de l'une ou l'autre série de N connecteurs de sortie vers N sorties (F0 - F6).

8. Procédé selon la revendication 7, caractérisé en ce que l'étape de multiplexage est commandée par un bit d'un générateur de séquences aléatoires.

## Patentansprüche

1. Einrichtung für Pseudozufallsschalten von N Strom- oder Spannungsquellen (E0 - E6), gekennzeichnet durch:
- ein erstes Mittel (A) zum Anschalten der N Quellen an eine erste Reihe von N Ausgangsleitungen (X0 - X6),
- ein zweites Mittel (B) zum Anschalten der N Quellen an eine zweite Reihe von N Ausgangsleitungen (X'0 - X'6), wobei das zweite Mittel die Anschaltung der Quellen mit Wahrscheinlichkeiten bewirkt, die symmetrisch sind zu einem Wert der gleichen Wahrscheinlichkeit des ersten Mittels,
- Mittel zum Multiplexen (C) der symmetrischen Leitungen ((X0, X'0) - (X6 - X'6)) am Ausgang des ersten und des zweiten Mittels und zum Verbinden einer der genannten Reihen mit einer im wesentlichen gleichen Wahrscheinlichkeit mit N Ausgängen (F0-F6).

2. Einrichtung nach Anspruch 1, dadurch gekennzeichnet, daß die Schaltmittel (A, B) durch identische Netzwerke mit Schaltern (S1 - S9) mit zwei Eingängen und zwei Ausgängen gebildet sind, daß dieselben Schalter der beiden Netzwerke (A, B) durch dasselbe Bit eines Zufallsfolgegenerators gesteuert sind, daß die N Eingänge eines der Schaltmittel in inverser Reihenfolge wie bei dem anderen Schaltmittel mit den Quellen (E0 - E6) verbunden sind.

3. Einrichtung nach Anspruch 2, dadurch gekennzeichnet, daß die N Ausgangsleitungen (X0 - X6), (X'0 - X'6) der beiden identischen Schalternetzwerke (A, B) in inverser Reihenfolge wie der andere bezeichnet sind, daß die Multiplexmittel (C) einen der Ausgänge der Schaltmittel unter zwei Ausgängen mit derselben Bezeichnung ((X0, X'0), (X6, X'6)) mit demselben Ausgang (F0-F6) der Multiplexmittel multiplexen.

4. Einrichtung nach einem der Ansprüche 2 oder 3, dadurch gekennzeichnet, daß die Schalternetzwerke (A, B) Netzwerke vom Typ "Butterfly" sind.

5. Einrichtung nach einem der Ansprüche 2 bis 4, dadurch gekennzeichnet, daß das Multiplexen der einen oder der anderen Reihe von Ausgangsleitungen durch ein zusätzliches Bit (S10) des Zufallsfolgegenerators gesteuert wird.

6. Einrichtung nach einem der Ansprüche 2 bis 5, wobei der Zufallsfolgegenerator ein Schieberegister enthält, das dadurch gebildet ist, daß an den Eingang des Registers der Ausgang eines EXKLUSIV-ODER-Gatters angeschlossen ist, dessen Eingänge mit einer bestimmten Zahl der Speicher des Registers verbunden sind.

7. Verfahren für Pseudozufallsschalten von N-Strom- oder Spannungsquellen (E0-E6), gekennzeichnet durch:
einen ersten Schritt zum Schalten der N Quellen an eine erste Reihe (X0 - X6) von N Ausgangsleitungen (X0-X6),
einen zweiten Schritt zum Schalten der N Quellen an eine zweite Reihe (X'0-X'6) von N Ausgangsleitungen, wobei die Wahrscheinlichkeiten des Schaltens bei dem zweiten Schritt symmetrisch sind zu denen des ersten Schrittes, verglichen mit einer gleichen Wahrscheinlichkeit,
einen Schritt zum Multiplexen der ersten oder der zweiten Reihe von N Ausgangsleitungen mit N Ausgängen (F0-F6) mit im wesentlichen gleicher Wahrscheinlichkeit.

8. Verfahren nach Anspruch 7, dadurch gekennzeichnet, daß der Schritt zum Multiplexen durch ein Bit eines Zufallsfolgegenerators gesteuert wird.

## Claims

1. Device for the pseudo-random switching of N current or voltage sources (EO - E6), characterized in that it comprises
- a first means (A) for switching the N sources to a first series of N output connectors (XO - X6),
- a second means (B) for switching the N sources to a second series of N output connectors (X'0 - X'6), the said second means carrying out the switching of the sources with probabilities which are symmetric with respect to an equiprobability value with respect to the first means,
- means (C) of multiplexing the symmetric output connectors ((X0, X'0) - (X6, X'6)) of each of the first and second means and linking one of the said series to N outputs (FO - F6) in a substantially equiprobable manner.

2. Device according to Claim 1, characterized in that the said switching means (A, B) consist of identical networks of switches (S1 - S9) with two inputs and two outputs, the same switches of the two networks (A, B) being controlled by one and the same bit from a generator of random sequences, the N inputs of one of the switching means being connected to the said sources (EO - E6) in reverse order with respect to the other switching means.

3. Device according to Claim 2, characterized in that the N output connectors (XO - X6, X'O - X'6) of the two identical networks (A, B) of switches are referenced in reverse order with respect to one another, the multiplexing means (C) multiplexing to one and the same output (FO - F6) of the said multiplexing means one of the outputs of the switching means from among two outputs with the same reference ((X0, X'0), (X6, X'6)).

4. Device according to one of Claims 2 or 3, characterized in that the said networks of switches (A, B) are "butterfly" type networks.

5. Device according to one of Claims 2 to 4, characterized in that the multiplexing of one or the other series of output connectors is controlled by a supplementary bit (S10) of the generator of random sequences.

6. Device according to one of Claims 2 to 5, the said generator of random sequences comprises a shift register having a return loop which is made by connecting to the input of this register the output of an exclusive or whose inputs are connected to a given number of memories of the said register.

7. Method for the pseudo-random switching of N current or voltage sources (EO - E6) characterized in that it comprises:
a first step of switching the N sources to a first series (XO - X6) of N output connectors,
a second step of switching the N sources to a second series (X'O - X'6) of N output connectors, the switching probabilities during the second step being symmetric with those of the first step with respect to the equiprobability,
a step of substantially equiprobable multiplexing of one or the other series of N output connectors to N outputs (FO - F6).

8. Method according to Claim 7, characterized in that the multiplexing step is controlled by a bit of a generator of random sequences.
